Europäisches Patentamt

European Patent Office

Office européen des brevets

(19)

(11) **EP 0 697 768 B1**

(12) **FASCICULE DE BREVET EUROPEEN**

(45) Date de publication et mention
de la délivrance du brevet:
**23.01.2002 Bulletin 2002/04**

(51) Int Cl.⁷: **H03K 5/1534**, H04L 7/033

(21) Numéro de dépôt: **95401893.3**

(22) Date de dépôt: **16.08.1995**

(54) **Détecteur de transition d'un signal logique engendrant une impulsion de durée calibrée**

Eine kalibrierte Impulsbreite erzeugender Detektor für den Übergang eines Logiksignals

Logic signal transition detector generating a calibrated pulse width

(84) Etats contractants désignés:
**DE GB IT NL**

(30) Priorité: **18.08.1994 FR 9410117**

(43) Date de publication de la demande:
**21.02.1996 Bulletin 1996/08**

(73) Titulaire: **ATMEL NANTES SA**
**44300 Nantes (FR)**

(72) Inventeur: **Neron, Christophe**
**F-44300 Nantes (FR)**

(74) Mandataire: **Fréchède, Michel**
**Cabinet Plasseraud 84, rue d'Amsterdam**
**F-75440 Paris Cédex 09 (FR)**

(56) Documents cités:
**EP-A- 0 104 761          EP-A- 0 392 653**
**DE-A- 4 326 134          US-A- 4 535 459**
**US-A- 4 789 976          US-A- 5 146 121**

- **PATENT ABSTRACTS OF JAPAN vol. 14, no. 312 (E-948) (4255) 5 Juillet 1990 & JP-A-02 100 514 (RICOH CO LTD) 12 Avril 1990**
- **PATENT ABSTRACTS OF JAPAN vol. 12, no. 293 (E-645) (3140) 10 Août 1988 & JP-A-63 069 315 (SONY CORP) 29 Mars 1988**
- **JOURNAL OF LIGHTWAVE TECHNOLOGY, vol.LT-3, no.6, Décembre 1985, NEW YORK, US pages 1312 - 1314 C. R. HOGGE, JR : 'A Self Correcting Clock Recovery Circuit'**
- **JOURNAL OF LIGHTWAVE TECHNOLOGY, vol.LT-5, no.10, Octobre 1987, NEW YORK, US pages 1510 - 1517 K. Y. MAXHAM ET AL : '1.13-Gbit/Lightwave Transmission System'**

# Description

L'invention concerne un détecteur de transition d'un signal logique engendrant une impulsion de durée calibrée.

Dans les circuits électroniques utilisés actuellement dans les techniques numériques ou informatiques, le problème de la synchronisation des éléments constitutifs de ces circuits est un problème majeur. En particulier, lorsque cette synchronisation est effectuée sur transition d'un signal numérique ou logique, il est primordial de pouvoir disposer, lors de l'apparition d'une telle transition, d'une impulsion de durée parfaitement calibrée, afin d'autoriser pendant la durée de cette impulsion, la mise en oeuvre de jeux d'instructions de commande divers.

Une solution connue, telle que décrite par exemple dans le document DE 4 326 134 A, consiste selon un schéma classique, tel que représenté en figure 1, à utiliser une porte logique OU exclusif à deux entrées, alimentées chacune directement respectivement par l'intermédiaire d'une ligne à retard par le signal dont la transition doit être détectée. La porte logique OU exclusif, sur apparition de la transition, délivre une impulsion dont la durée est égale à la durée du retard introduit par la ligne à retard sur le signal d'entrée.

Afin de mettre en oeuvre le retard précité, on utilise soit une ligne à retard de type analogique, soit des circuits ou portes logiques élémentaires introduisant chacune un retard de propagation élémentaire.

Dans le premier cas d'utilisation d'une ligne à retard analogique, le retard introduit est très stable, sur une large gamme de conditions de fonctionnement. Ce type de composant n'est toutefois pas intégrable, et doit donc être introduit comme élément extérieur.

Dans le deuxième cas, la durée du retard introduit est très dépendante des variations des conditions de fonctionnement, telles que la température par exemple. Le principal avantage dans le deuxième cas précité est toutefois que ce type de circuit est parfaitement intégrable.

Le document US 4 789 976 décrit un dispositif de compensation de retard dû à la température dans un système de commande de rotation de vidéodisque. Le dispositif comporte un circuit de compensation de retard dans lequel un oscillateur en anneau 20 et un oscillateur à quartz 32 sont utilisés. Du fait de la présence de ces deux éléments, le dispositif de compensation est complexe à mettre en oeuvre et, par conséquent, plus coûteux.

Le document EP-A-0 392 653 décrit un système d'extraction d'horloge mettant en oeuvre une porte logique de type ET ou NON-ET et une ligne à retard pilotée en synchronisation par une boucle de phase munie d'un oscillateur en anneau, lequel permet d'assurer cette synchronisation sur les fronts d'un signal d'horloge. Toutefois, un tel système ne permet pas d'engendrer des impulsions de durée calibrée, en l'absence d'une commande du retard apporté par la ligne à retard, la porte logique de type ET ou NON-ET servant au masquage des impulsions de données.

La présente invention a pour but de remédier aux inconvénients précités.

Elle a pour objet la mise en oeuvre d'un détecteur de transition d'un signal logique engendrant une impulsion de durée calibrée de grande précision quoique parfaitement intégrable, et son application à la réalisation d'un comparateur de phase.

Le détecteur de transition d'un signal logique, objet de la présente invention, comprend une porte logique OU exclusif dont une première entrée reçoit ce signal logique par l'intermédiaire d'un circuit de retard déterminé.

Il est remarquable en ce qu'il comprend en outre un circuit de retard auxiliaire associé au circuit de retard par une boucle à verrouillage de phase, laquelle permet d'engendrer, à partir d'un signal de fréquence de référence, un signal de commande de phase commun permettant d'asservir le retard apporté par le circuit de retard et par le circuit de retard auxiliaire à une valeur proportionnelle à la période du signal de fréquence de référence, ce qui permet d'engendrer, pour chaque transition du signal logique, une impulsion calibrée dont la durée est proportionnelle à la période du signal de fréquence de référence.

Le détecteur de transition, objet de la présente invention, trouve notamment application à la réalisation de mémoires électroniques sous forme de circuits intégrés.

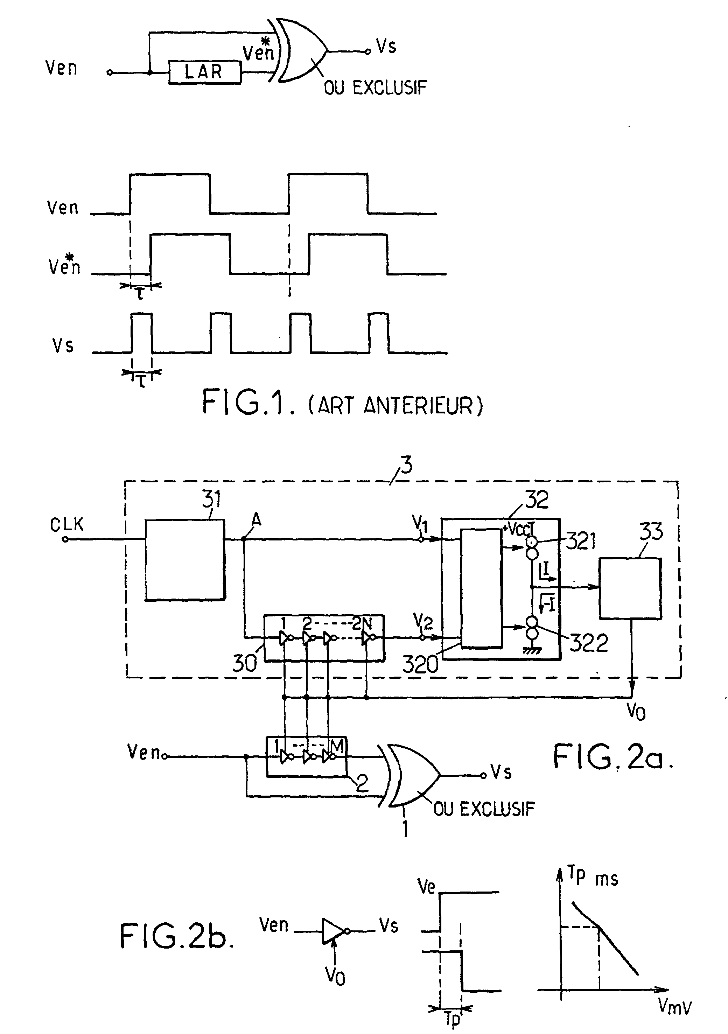

Il sera mieux compris à la lecture de la description et à l'observation des dessins ci-après dans lesquels, outre la figure 1 relative à l'art antérieur,

- la figure 2a représente un schéma synoptique de réalisation du détecteur de transition, objet de la présente invention,
- la figure 2b représente un diagramme de temps de retard, tension de commande des inverseurs élémentaires utilisés pour constituer le circuit de retard et le circuit de retard auxiliaire,
- la figure 2c représente un chronogramme des signaux obtenus dans un cas spécifique de mise en oeuvre du détecteur de transition, objet de la présente invention, tel que représenté en figure 2a,
- la figure 3a représente un mode de réalisation particulier du détecteur de transition, objet de la présente invention, tel que représenté en figure 2a,
- la figure 3b représente un chronogramme de signaux relatifs au mode de réalisation de la figure 3a,
- les figures 4a à 4c concernent une application du détecteur de transition, objet de l'invention, à la réalisation d'un comparateur de phase.

Une description plus détaillée d'un détecteur de transition d'un signal logique engendrant une impulsion de durée calibrée, conforme à l'objet de la présente invention, sera maintenant donnée en liaison avec la figure 2a et les figures suivantes.

Ainsi qu'on l'a représenté sur la figure précitée, on indique que le détecteur de transition d'un signal logique, objet de la présente invention, comprend une porte logique de type OU exclusif, référencée 1, dont une première entrée reçoit le signal logique, noté Ven, sur lequel la transition doit être détectée et dont une deuxième entrée reçoit ce même signal logique par l'intermédiaire d'un circuit de retard déterminé, référencé 2.

En outre, le détecteur de transition, objet de la présente invention, comprend un circuit de retard auxiliaire, noté 30, associé au circuit de retard 2 par l'intermédiaire d'une boucle à verrouillage de phase, référencée 3. La boucle à verrouillage de phase 3 permet d'engendrer, à partir d'un signal de fréquence de référence dont le rapport cyclique est de préférence égal à 1/2, noté CLK, un signal de commande de phase, noté V0, commun au circuit de retard déterminé 2 et au circuit de retard auxiliaire 30 et permettant d'asservir le retard apporté par le circuit de retard 2 et par le circuit de retard auxiliaire 30 à une valeur proportionnelle à la période du signal de fréquence de référence CLK. On comprend ainsi que, en raison de l'asservissement du retard du circuit de retard 2 et du circuit de retard auxiliaire 30 à une valeur proportionnelle à la période du signal de fréquence de référence précité, le retard engendré par le circuit de retard 2 est ainsi fixé, ce qui permet d'engendrer en sortie du circuit OU exclusif 1 une tension de sortie Vs correspondant à une impulsion de durée calibrée dont le retard est égal à la durée du retard apporté par le circuit de retard 2.

Afin de réaliser les fonctions de retard commandé par l'intermédiaire du signal de commande de phase commun V0, on indique, de manière avantageuse, ainsi que représenté sur la figure 2a précitée, que le circuit de retard 2 est formé par une pluralité de M inverseurs à temps de propagation contrôlé, connectés en cascade, alors que le circuit de retard auxiliaire 30 est formé par une pluralité de 2N circuits inverseurs à temps de propagation contrôlé, également connectés en cascade, les inverseurs du circuit de retard 2 et du circuit de retard auxiliaire 30 étant commandés par le signal de commande de phase V0 délivré par la boucle à verrouillage de phase 3.

Bien entendu, et dans un mode de réalisation pratique, on indique que, tant les inverseurs du circuit de retard 2 que ceux du circuit de retard auxiliaire 3, sont identiques, les circuits résultants étant ainsi appairés, ce qui bien entendu permet d'obtenir une valeur parfaitement stable de la durée de l'impulsion calibrée Vs délivrée par le circuit logique OU exclusif 1.

En référence à la figure 2b, on indique que chaque inverseur est commandé par la même tension de commande de phase V0. En conséquence, chacun des inverseurs a son temps de propagation contrôlé et commandé par cette tension, et le temps de retard Tp apporté par chaque inverseur du circuit de retard 2 respectivement du circuit de retard auxiliaire 30 a pour valeur Tp en millisecondes pour une valeur de tension du signal de commande de phase V0.

A l'équilibre de la boucle de verrouillage de phase, chaque inverseur est asservi par la tension de commande de phase V0 et présente le temps de propagation élémentaire Tp vérifiant la relation :

$$Tp = \frac{1}{2N \times Fref} = \frac{Tref}{2N}$$

où 2N représente le nombre d'inverseurs connectés en cascade dans le circuit de retard auxiliaire 30 et Tref désigne la période du signal de référence CLK.

On indique qu'en conséquence, le temps de retard élémentaire Tp apporté par chaque inverseur est proportionnel à la période du signal de fréquence de référence CLK. Ce temps est donc aussi précis et aussi stable que la fréquence du signal de fréquence de référence CLK.

En ce qui concerne le circuit de retard 2, on indique que les inverseurs étant identiques à ceux du circuit de retard auxiliaire 30 et commandés par la même tension de commande de phase V0, le temps de retard $\tau$ apporté par les M inverseurs du circuit de retard 2 est égal à :

$$\tau = M \times Tp = \frac{M}{2N} \times Tref.$$

On comprend ainsi que grâce à la mise en oeuvre d'une boucle de verrouillage de phase entre le signal d'horloge de référence CLK et le signal d'horloge de référence retardé par le circuit de retard auxiliaire 30, pour un retard apporté par le circuit de retard auxiliaire 30 égal à la période du signal de fréquence de référence CLK, le signal de commande de phase V0 délivré par la boucle de verrouillage de phase a une valeur stable correspondant à un régime d'équilibre de phase de ces signaux. Le retard apporté par le circuit de retard 2, lequel est asservi en durée de retard par l'intermédiaire du signal de commande de phase V0, est donc proportionnel au rapport du nombre d'inverseurs connectés en cascade dans le circuit de retard 2 au nombre d'inverseurs connectés en cascade dans le circuit de retard auxiliaire 30 et à la valeur de la période du signal de fréquence de référence CLK.

Ainsi qu'on l'a représenté en outre en figure 2a, on indique que la boucle à verrouillage de phase 3 peut comporter au moins un circuit 31 de mise en forme du signal de fréquence de référence CLK, ce circuit 31 étant destiné à la mise en forme de ce signal et, le cas échéant, constitué par un diviseur par deux afin de délivrer un signal de rapport cyclique 1/2. La boucle de verrouillage phase comporte également un comparateur phase/fréquence à trois états, portant la référence 32, recevant sur une première entrée le signal de fréquence de référence CLK ou le signal mis en forme par le circuit 31 précité au point de test A de la figure 2a. Il reçoit sur une deuxième entrée V2 le signal de fréquence de référence ou le signal mis en forme par le circuit 31, délivré par l'intermédiaire du circuit de retard auxiliaire, c'est-à-dire le signal de fréquence de référence soumis au retard des 2N inverseurs constituant le circuit de retard auxiliaire 30. Le comparateur phase/fréquence 32 délivre un signal de comparaison de valeur nulle en l'absence de décalage phase/fréquence entre les signaux de la première et de la deuxième entrée précitées et un signal de valeur positive ou négative proportionnel au décalage phase/fréquence entre les signaux de la première et de la deuxième entrée.

De manière classique, on indique que le comparateur phase/fréquence à trois états 32 peut être constitué par un comparateur phase/fréquence proprement dit 320, lequel pilote deux générateurs d'intensité, notés 321 et 322, délivrant un signal +I, respectivement -I, les générateurs d'intensité 321 et 322 étant commandés par tout ou rien, ce qui permet d'obtenir les trois états correspondant respectivement aux signaux +I, +I-I = 0, -I. Le signal résultant délivré par les deux générateurs d'intensité 321 et 322, constitue le signal de sortie du comparateur phase/fréquence à trois états 32. Le signal de sortie précité est délivré à un filtre passe-bas 33, lequel a pour fonction essentielle d'intégrer ce signal de sortie afin de délivrer le signal de commande de phase V0 précédemment mentionné.

Lorsque le régime de la boucle à verrouillage de phase ainsi formé est atteint, le signal de commande de phase V0 présente une valeur déterminée correspondant à la valeur intégrée du signal de sortie délivré par la comparateur phase/fréquence à trois états et le retard apporté par le circuit de retard auxiliaire 30 est égal à la période du signal de fréquence de référence CLK ou à tout le moins du signal délivré par le circuit de mise en forme 31 au point A.

Dans ces conditions, on indique que le retard apporté par le circuit de retard 2 est également asservi à une valeur calibrée correspondant aux M retards élémentaires Tp apportés par chacun des inverseurs constitutifs du circuit de retard 2 précité.

D'une manière générale, on indique que le comparateur phase/fréquence à trois états et en particulier le comparateur proprement dit 320 peut être réalisé soit par l'intermédiaire d'un comparateur en technologie CMOS, ce type de comparateur étant actif à l'état bas c'est-à-dire sur le front descendant des transitions, soit par l'intermédiaire d'un comparateur bipolaire au moyen de portes NON-OU, ce type de comparateur étant actif à l'état haut, c'est-à-dire sur le front montant des transitions.

Dans le cas où, pour réaliser la boucle à verrouillage de phase, l'on utilise un comparateur de type CMOS précité, la liaison entre le point A de la figure 2a et la première entrée V1 du comparateur phase/fréquence à trois états 32 peut être constituée par une liaison directe et le nombre d'inverseurs montés en cascade pour réaliser le circuit de retard auxiliaire 30 peut être un nombre impair.

Au contraire, lorsque le nombre d'inverseurs constitutifs du circuit de retard auxiliaire 30 est un nombre pair, la liaison entre le point A, le point de sortie du circuit de mise en forme 31 délivrant les signaux de fréquence de référence de rapport cyclique 1/2 à l'entrée V1 du comparateur phase/fréquence à trois états, doit être effectuée par l'intermédiaire d'un inverseur et un retard correspondant doit être apporté à l'entrée du circuit de retard auxiliaire 30.

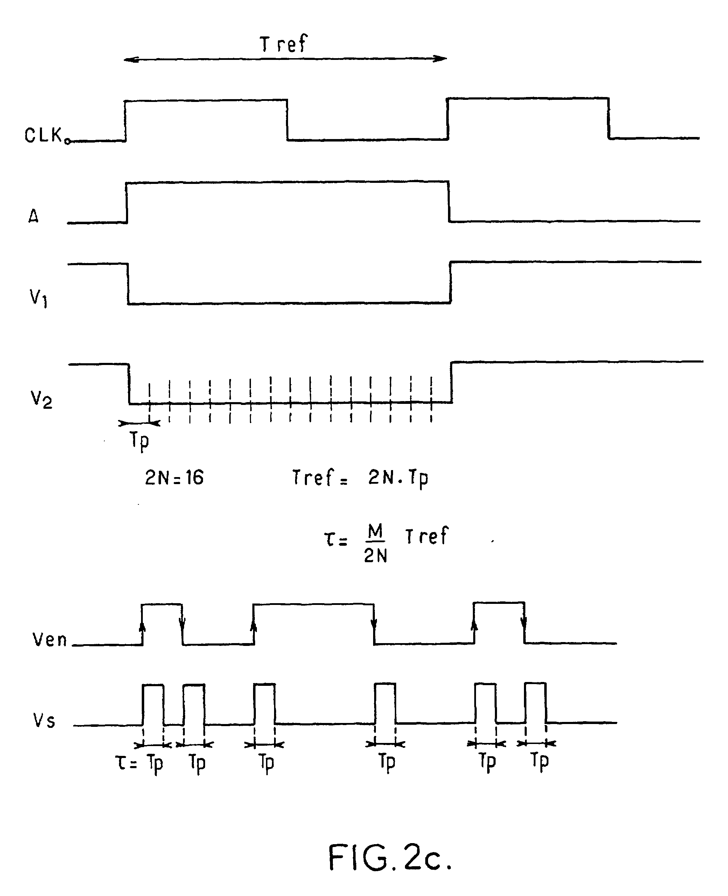

Les chronogrammes aux points de test de la figure 2a sont donnés en figure 2c, dans un exemple de réalisation non limitatif dans lequel N = 8, nombre d'inverseurs constituant le circuit de retard auxiliaire 30 et M = 1, nombre d'inverseurs constituant le circuit de retard 2.

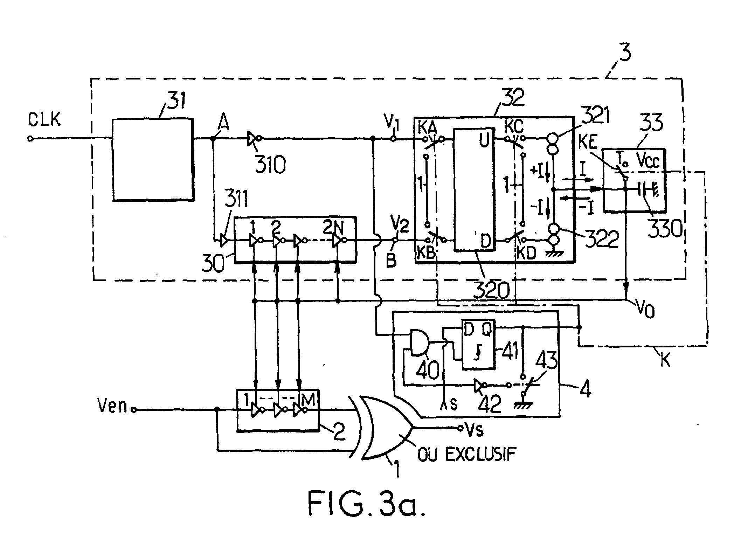

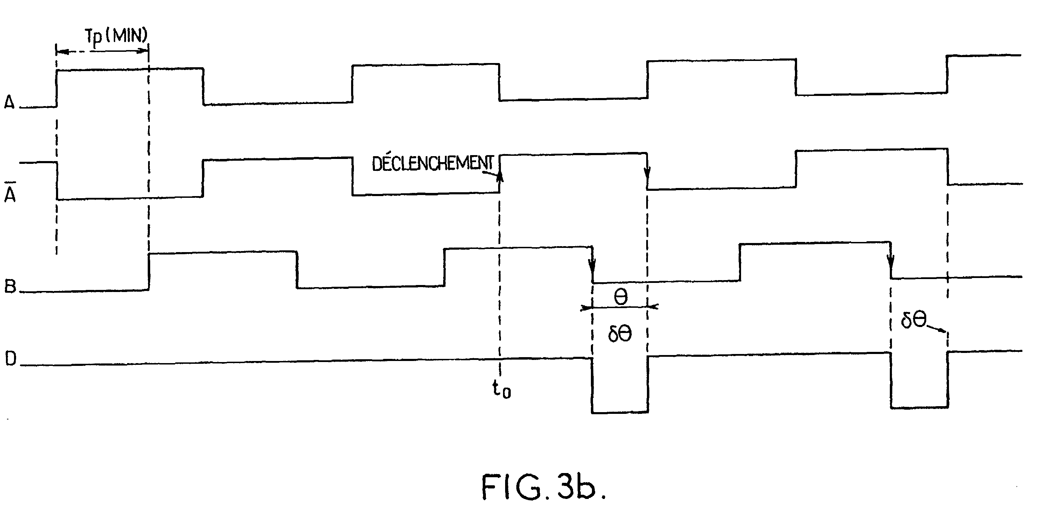

Une description plus détaillée d'une mode de réalisation préférentiel du détecteur de transition d'un signal logique, objet de la présente invention, sera maintenant donnée en liaison avec les figures 3a et 3b dans le cas où le nombre d'inverseurs constitutifs du circuit de retard auxiliaire 30 est pair et égal à 2N, la liaison entre le point A de sortie du circuit de mise en forme 31 et le point V1 d'entrée du comparateur phase/fréquence à trois états 32 étant réalisée par un inverseur 310, et le retard apporté par cet inverseur étant compensé, au niveau de l'entrée du circuit de retard auxiliaire 30, par l'intermédiaire d'un circuit non-inverseur 311 apportant le même retard que le circuit inverseur 310.

Le mode de réalisation de la figure 3a correspond à un mode de réalisation dans lequel la boucle à verrouillage de phase 3 est complétée par un circuit d'initialisation 4 du comparateur phase/fréquence 32 à trois états et du retard global initial apporté par le circuit de retard auxiliaire 30 à sa valeur minimale, c'est-à-dire à une valeur d'initialisation correspondant à la tension de commande de phase V0 la plus faible sur la figure 2b. Ce mode opératoire permet d'autoriser une augmentation de la valeur du retard global apporté par le circuit de retard auxiliaire 30 jusqu'à une valeur d'équilibre correspondant à la période du signal de fréquence de référence, ainsi que précédemment mentionné.

Ainsi qu'on l'a représenté sur la figure 3a précitée, le circuit d'initialisation du comparateur phase/fréquence à trois états 32 comporte avantageusement des circuits interrupteurs commandés KA, KB, KC, KD, ces circuits interrupteurs commandés étant placés entre l'entrée V1 du comparateur phase/fréquence 32, l'entrée V2 du comparateur phase/fréquence 32, la sortie de commande du générateur d'intensité 321 et la sortie de commande du générateur d'intensité 322 respectivement. Les circuits interrupteurs KA, KB, KC, KD permettent la commutation des entrées du comparateur de phase proprement dit 320, respectivement des sorties de celui-ci, à une valeur logique 1, correspondant par exemple à la tension d'alimentation VCC du dispositif, respectivement à la valeur des entrées V1, V2, respectivement des sorties correspondantes U, D du comparateur phase/fréquence proprement dit 320 pour commander les générateurs d'intensité 321, 322.

En outre, dans le mode de réalisation de la figure 3a, on indique que le filtre passe-bas 33 peut être constitué par une capacité d'intégration, notée 330, laquelle est reliée à la sortie du comparateur phase/fréquence trois états 32 d'une part, et, d'autre part, à la tension d'alimentation VCC par l'intermédiaire d'un interrupteur commandé KE, la capacité d'intégration 330 étant d'autre part reliée à la tension de référence. La borne de la capacité d'intégration 330, reliée à l'interrupteur commandé KE et à la sortie du comparateur phase/fréquence 32, délivre la tension de commande de phase V0 au circuit de retard auxiliaire 30 et au circuit de retard 2.

En outre, ainsi qu'on l'a représenté sur la figure 3a précitée, la boucle à verrouillage de phase 3 est complétée par un circuit d'initialisation proprement dit 4, lequel comporte une porte logique de type ET 40 dont une première entrée est connectée à la borne d'entrée V1 du comparateur phase/fréquence 32, en amont de l'interrupteur commandé KA et dont une deuxième entrée est reliée à un signal de commande de synchronisation S. La sortie de la porte logique ET 40 est reliée à une bascule 41 dont l'entrée D reçoit le signal de synchronisation S. La sortie Q de la bascule 41 est reliée à un interrupteur commandé 43, lui-même relié à la tension de référence, cet interrupteur commandé 43 étant commandé, par l'intermédiaire d'un inverseur 42, par l'intermédiaire du signal de synchronisation S. La sortie Q de la bascule 41 délivre un signal de commande de l'ensemble des interrupteurs commandés KA, KB, KC, KD, KE.

Le circuit d'initialisation tel que décrit en relation avec la figure 3a opère de la manière ci-après.

Avant de démarrer la mise en synchronisation du détecteur, il est nécessaire de positionner correctement le comparateur phase/fréquence 32 et la valeur initiale du retard apporté par le circuit de retard auxiliaire 30 à des valeurs d'initialisation.

Dans ce but :

- 1) le comparateur phase/fréquence 32 doit être initialement positionné dans son état stable, désigné sous le vocable anglo-saxon par "tristate", et doit être en attente d'un premier front pour effectuer une première correction de la valeur de retard apporté par le circuit de retard auxiliaire 30. Pour un comparateur actif sur front descendant et à niveau actif à l'état bas, il suffit de positionner à un instant t = 0 les entrées/sorties, c'est-à-dire les valeurs des entrées V1, V2 et des sorties du comparateur phase/fréquence proprement dit 320 commandant les générateurs d'intensité 321 et 322 à l'état haut, c'est-à-dire à l'état logique 1.
- 2) Le délai ou temps de retard de propagation dans les 2N inverseurs du circuit de retard auxiliaire 30 doit également être positionné à sa valeur minimale à l'instant t = 0 précité. Dans le cas où la caractéristique retard/tension présente une pente négative, ainsi que représenté en figure 2b, une telle contrainte revient à forcer initialement V0, tension de commande de phase, à sa valeur maximale.

- 3) Il faut enfin provoquer un démarrage correct de la synchronisation afin que le comparateur phase/fréquence 32 et en particulier le comparateur phase/fréquence proprement dit 320, commence à comparer dans le bon sens, c'est-à-dire dans le sens consistant à permettre d'augmenter la valeur du retard, par diminution de la tension de commande de référence à partir de la valeur initiale de celle-ci.

Le fonctionnement du dispositif tel que représenté en figure 3a peut alors être résumé de la façon ci-après :

- si S = 0, alors, l'interrupteur commandé 43 se ferme et le signal délivré en sortie Q de la bascule 41 est forcé à 0, provoquant la commande des interrupteurs commandés KA, KB, KC, KD, KE en position de commutation vers le niveau logique haut, le niveau 1 sur la figure 3a.

Dans cet état, le comparateur phase/fréquence 32 et en particulier le comparateur phase/fréquence proprement dit 320 est isolé dans son état stable, les entrées-sorties de ce dernier étant positionnées à la valeur du niveau logique haut 1. Dans ce cas, le délai à travers les 2N inverseurs est minimum et correspond à une valeur notée Tp(MIN) déterminée.

Sur passage du signal de synchronisation S à la valeur logique haute, soit pour S = 1, le signal complémenté $\bar{A}$ délivré par l'inverseur 310 est appliqué sur l'entrée de commande ou horloge de la bascule 41 et la sortie Q de celle-ci est alors commandée à l'état 1, le signal de commande des interrupteurs KA, KB, KC et KD étant ainsi libéré. La bascule 41 passe à l'état 1 au premier front montant du signal $\bar{A}$ précité et provoque ainsi la commutation des interrupteurs commandés KA, KB, KC, KD, KE.

Juste après la détection d'un front montant du signal $\bar{A}$ précité, le signal $\bar{A}$ délivré par l'inverseur 310 et le signal B délivré par le circuit de retard auxiliaire 30 sont obligatoirement à l'état haut et le premier front descendant qui se présente est un front descendant de B, lequel est appliqué sur l'entrée V2 et par l'intermédiaire de l'interrupteur commandé KB, au comparateur phase/fréquence proprement dit 320. Le comparateur permet alors d'effectuer la comparaison dans le sens de l'augmentation du retard et donc de la diminution de la tension de commande de phase V0.

Les différents paramètres précités sont représentés sur la figure 3b sur laquelle sont représentés successivement le signal A délivré en sortie du circuit de mise en forme 31, le signal $\overline{A}$ complémenté de ce dernier, délivré par l'inverseur 310, le signal B délivré par le circuit de retard auxiliaire 30 et le signal D délivré en sortie D du comparateur phase/fréquence proprement dit 320, c'est-à-dire lorsque l'interrupteur commandé KD est fermé, en commande du générateur d'intensité 322.

Ainsi que représenté sur la figure 3b, le mode opératoire est le suivant :

- a) on libère le comparateur phase/fréquence précédemment à son état isolé et stable sur un front montant du signal $\overline{A}$, cet instant de libération étant désigné par déclenchement à l'instant t0 sur la figure 3b car juste après cet instant, un front descendant du signal B apparaît et se présente en premier, ce front entraînant la sortie D du comparateur phase/fréquence proprement dit 320 à une valeur active et donc une diminution de la valeur de la tension de commande de phase V0, par décharge de la capacité d'intégration 320.
- b) le passage du signal de synchronisation S de la valeur 0 à la valeur 1 peut intervenir à n'importe quel moment. Le signal S est en fait un bit de synchronisation du système, utile en cas de perte accidentelle de la synchronisation.
- c) après l'instant t0, l'entrée V1 du comparateur phase/fréquence 32 est à la valeur logique $\overline{A}$ et, bien entendu, après fermeture de l'interrupteur commandé KA, l'entrée correspondante proprement dite du comparateur phase/fréquence proprement dit 320 est à cette même valeur alors que l'entrée V2 est à la valeur logique B et, après fermeture de l'interrupteur commandé KB, l'entrée correspondante du comparateur phase/fréquence proprement dit 320 est à cette même valeur.

On a ainsi décrit un détecteur de transition d'un signal logique permettant d'engendrer une impulsion de durée calibrée.

Les modes de réalisation de ce détecteur peuvent être variés sans toutefois sortir du cadre de l'objet de la présente invention. On indique qu'il est possible d'utiliser un comparateur phase/fréquence sensible sur front montant ou descendant des signaux, des portes non-inverseuses à la place d'inverseurs ainsi que des bascules constituant soit le diviseur par deux du circuit de mise en forme 31, soit la bascule 41, sensible sur front montant ou descendant. Le nombre M d'inverseurs montés en cascade pour réaliser le circuit de retard 2 peut être pair ou impair et enfin, la porte OU exclusif 1 peut être remplacée par un circuit de type NON-OU équivalent en logique complémentée correspondante.

On indique également que dans le cas où le signal de fréquence de référence CLK a un rapport cyclique constant égal à 0,5, le circuit de mise en forme constitué normalement par une bascule bistable 31 peut être supprimé.

De la même manière, on indique que le temps de propagation Tp des inverseurs peut être effectué soit en tension, par l'intermédiaire de la tension de commande de phase V0, soit également en courant.

Le comparateur phase/fréquence proprement dit 320 peut être constitué soit à base de circuits logiques de type NON-OU, soit de type NON-ET.

Enfin, on indique que, afin d'assurer un fonctionnement correct du circuit détecteur, objet de la présente invention, un fonctionnement correct de celui-ci est assuré pour des transitions successives espacées d'une durée supérieure au temps de retard apporté par le circuit de retard 2, c'est-à-dire une durée supérieure à :

$$\tau = \frac{M}{2N} \times \text{Tref}.$$

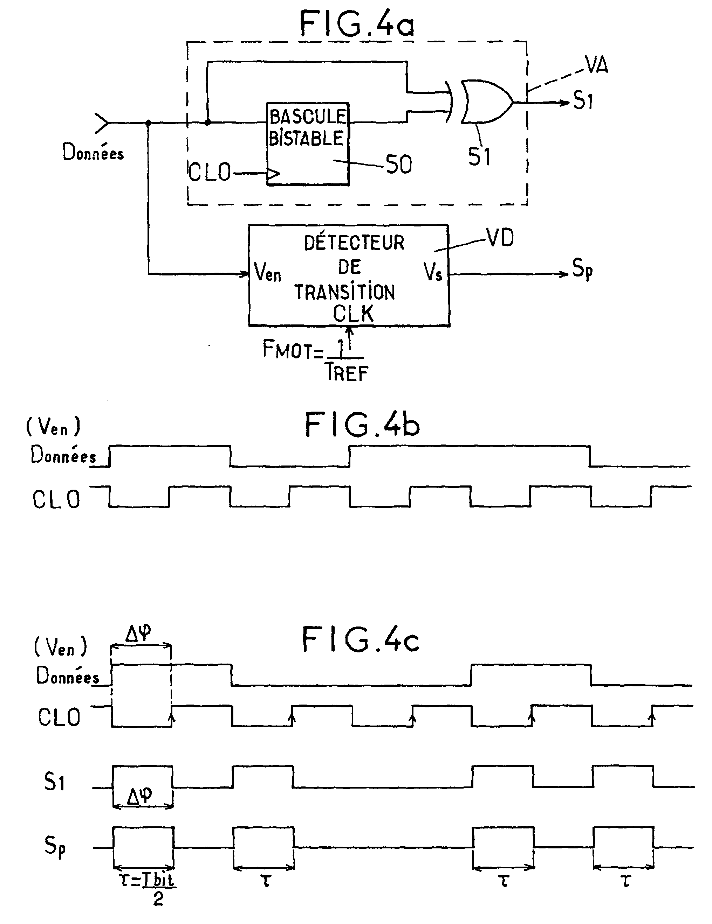

Une application du détecteur de transition d'un signal logique, objet de la présente invention telle que précédemment décrit, à un dispositif de comparaison de phase du type comparateur de HOGGE tel que décrit dans l'article *"A Self Correcting Clock Recovery Circuit"*, publié par Charles G.HOGGE Jr. - Journal of Lightwave Technology, Vol. LT-3, No. 6 December 1985, 1985 IEEE, sera maintenant donnée en liaison avec les figures 4a, 4b et 4c.

En vue de réaliser un comparateur de phase, tel que précédemment mentionné, au détecteur VD, détecteur de transition tel que décrit précédemment dans la description, est associée en parallèle sur le flux de données représentées par le signal logique une voie auxiliaire VA formée par une bascule bistable, noté 50, et une porte OU de type exclusif, noté 51. La bascule bistable 50 reçoit un signal d'horloge associé au signal logique d'entrée, représenté par "Données", ce signal étant également délivré sur une entrée de la porte de type OU exclusif 51. La sortie de la bascule bistable délivre un signal logique synchronisé sur le signal d'horloge, noté CLO, ce signal étant délivré à l'entrée d'horloge de la bascule bistable 50.

La voie auxiliaire VA décrite ci-dessus ainsi que le détecteur VD recevant le signal "Données" sur son entrée Ven et délivrant le signal Sp par l'intermédiaire de sa sortie Vs, délivrent chacun une impulsion de comparaison de phase de même amplitude crête à crête. Les impulsions engendrées par le détecteur VD et correspondant au signal noté Sp ont une durée constante et égale à la valeur Tp (voir Fig. 2c). Les impulsions engendrées par la voie auxiliaire VA et correspondant au signal S1 ont une durée variable, laquelle est une mesure du déphasage du signal logique "Données" par rapport au signal d'horloge CLO. En raison de la même amplitude crête à crête en valeur et en signe, c'est-à-dire pour un même sens de transition des deux impulsions délivrées par la voie de détection VD et la voie auxiliaire VA, une mesure différentielle de la valeur moyenne des deux signaux S1 et Sp peut être effectuée avec ondulation crête du signal différentiel minimale lorsque l'équilibre de phase est atteint.

On indique que le dispositif tel que représenté en figure 4a permet de réaliser un comparateur de phase de même type que le comparateur de HOGGE précédemment décrit, mais avec l'avantage de pouvoir annuler le déphasage de 180° entre les deux impulsions de comparaison délivrées par la voie de détection VD et la voie auxiliaire VA.

On indique que le dispositif comparateur de phase tel que décrit en figure 4a peut être utilisé dans une boucle à asservissement de phase (PLL) destinée à extraire l'horloge série CLO du signal de données numériques correspondant "Données", et qu'il peut aussi être utilisé pour différents types de format d'encodage de données numériques.

Un exemple de réalisation sera donné en liaison avec le cas d'un codage de données de type NRZ ("no return to zero" en langage anglo-saxon).

Pour un signal de données numériques ou signal logique de type NRZ précédemment cité et désigné par "Données" et son signal d'horloge associé CLO, le signal de données présente une période bit désignée par $T_{bit}$.

Dans les dispositifs de transmission numérique série où émetteur et récepteur sérialise puis désérialise un ensemble de bus de données numériques parallèle, il existe presque toujours une fréquence de référence, de type signal délivré par un oscillateur à quartz, permettant de cadencer et de synchroniser l'ensemble de la transmission. Cette fréquence est généralement plus faible que le débit série et est sensiblement égale, aux erreurs de la fréquence de référence près, à la vitesse de transmission de plusieurs bits série consécutifs. Cette fréquence est généralement désignée par fréquence MOT, $F_{MOT}$, et est liée à la fréquence bit, inverse de la période bit, par la relation :

$$F_{bit} = \frac{F_{MOT}}{P}.$$

La valeur du paramètre P qui est un nombre entier dépend du type de décodeur-encodeur utilisé.

L'utilisation du signal de fréquence de référence précédemment mentionné $F_{MOT}$ pour cadencer la voie de détection VD de transition permet d'écrire :

$$F_{MOT} = \frac{1}{Tref}.$$

On comprend alors que la voie de détection VD correspondant aux circuits détecteurs de transition tels que représentés en figure 2a ou 3a, par exemple, reçoit pour signal d'horloge CLK le signal de fréquence de référence $F_{MOT}$ précité.

Dans ces conditions, le signal de sortie de la voie de détection VD engendre des impulsions de durée constante égales à :

$$\tau = \frac{M}{2N} \, Tref$$

ou encore :

$$\tau = \frac{M \times P}{2N} T_{bit}$$

Pour une valeur particulière de M,N et P, pour que le produit MP=N, on obtient alors :

$$T = \frac{T_{bit}}{2}.$$

Un exemple de chronogramme en phase est donné sur la figure 4c pour laquelle à l'équilibre l'écart de phase $\Delta\Phi$ entre les signaux S1 délivré par la voie auxiliaire VA et Sp délivré par la voie de détection VD est donné en figure 4c.

On indique que les impulsions S1 et Sp sont en phase à l'équilibre, ce qui, pour une détection différentielle de valeur moyenne sur les signaux S1 et Sp, permet de mesurer le déphasage avec une ondulation crête réduite comparativement au dispositif de HOGGE. La propriété remarquable d'autocentrage d'un front montant d'horloge CLO en milieu de bit du signal numérique "Données" est également maintenue. De plus l'excursion statique de phase du comparateur de phase ainsi réalisée reste égale à égale à ± 180°.

La fréquence bit, $F_{bit}$, étant généralement liée à la fréquence mot, $F_{MOT}$, par un rapport de division entier et constant P, on comprend aisément qu'une modification de $F_{bit}$ entraîne également une modification proportionnelle de $F_{MOT}$. Ainsi, on indique en outre que le fonctionnement du comparateur de phase décrit ci-dessus est indépendant de la fréquence bit, $F_{bit}$, tant que la valeur de P ne change pas et que la durée d'impulsions du signal Sp reste compatible avec un fonctionnement normal de la voie de détection VD.

Toutefois, on indique que le dispositif tel que représenté en figure 4a ne fonctionne que lorsque le détecteur de transition est stabilisé et synchronisé. Il existe donc un temps d'établissement initial inhérent à la structure du dispositif tel que représenté en figure 4a.

## Revendications

1. Détecteur de transition d'un signal logique comprenant une porte logique OU exclusif dont une première entrée reçoit ledit signal logique et dont une deuxième entrée reçoit ledit signal logique par l'intermédiaire d'un circuit de retard déterminé, ledit détecteur comprenant en outre un circuit de retard auxiliaire associé audit circuit de retard par une boucle à verrouillage de phase, ladite boucle à verrouillage de phase permettant d'engendrer, à partir d'un signal de fréquence de référence, un signal de commande de phase commun permettant d'asservir le retard apporté par ledit circuit de retard ledit signal de fréquence de référence étant appliqué à l'entrée du circuit de retard auxiliaire et ledit circuit de retard auxiliaire à une valeur proportionnelle à la période du signal de fréquence de référence, ce qui permet d'engendrer pour chaque transition du signal logique une impulsion calibrée dont la durée est proportionnelle à la période du signal de fréquence de référence.

2.  Détecteur selon la revendication 1, **caractérisé en ce que** ledit circuit de retard est formé par une pluralité de M inverseurs à temps de propagation contrôlé, connectés en cascade, et **en ce que** ledit circuit de retard auxiliaire est formé par une pluralité de 2N circuits inverseurs à temps de propagation contrôlé, connectés en cascade, lesdits inverseurs étant commandés par ledit signal de commande de phase délivré par ladite boucle à verrouillage de phase.

3.  Détecteur selon la revendication 2, **caractérisé en ce que** lesdits inverseurs constituant ledit circuit de retard respectivement le circuit de retard auxiliaire sont identiques, le retard $\tau$ engendré par ledit circuit de retard étant égal au produit du rapport du nombre M d'inverseurs formant le circuit de retard au nombre 2N d'inverseurs formant le circuit de retard auxiliaire et de la période Tref du signal de fréquence de référence,

$$\tau = \frac{M}{2N} \text{ x Tref}$$

4.  Détecteur selon l'une des revendications 1 à 3, **caractérisé en ce que** ladite boucle à verrouillage de phase comporte au moins :

    -   un comparateur phase/fréquence à trois états recevant sur une première entrée ledit signal de fréquence de référence et sur une deuxième entrée ledit signal de fréquence de référence délivré par l'intermédiaire dudit circuit de retard auxiliaire, ledit comparateur phase/fréquence délivrant un signal de comparaison de valeur nulle en l'absence de décalage phase/fréquence entre les signaux de la première et de la deuxième entrée respectivement, un signal de valeur positive ou négative proportionnel au décalage phase/fréquence entre les signaux de la première et de la deuxième entrée,
    -   un filtre passe-bas recevant ledit signal de comparaison et délivrant ledit signal de commande de phase commun délivré audit circuit de retard et circuit de retard auxiliaire.

5.  Détecteur selon la revendication 4, **caractérisé en ce que** ladite boucle à verrouillage de phase comporte en outre des moyens d'initialisation dudit comparateur phase/-fréquence à trois états et du retard global initial apporté par ledit circuit de retard auxiliaire, à sa valeur minimale, de façon à autoriser une augmentation de la valeur du retard global apporté par ledit circuit de retard auxiliaire jusqu'à une valeur d'équilibre correspondant à la période du signal de référence.

6.  Utilisation d'un détecteur de transition d'un signal logique selon l'une des revendications précédentes pour réaliser un comparateur de phase, dans laquelle audit détecteur est associée en parallèle sur le flux des données représentées par ledit signal logique une voie auxiliaire formée par une bascule bistable recevant un signal d'horloge associé audit signal logique et une porte de type OU exclusif, une entrée de ladite porte de type OU exclusif et l'entrée de données de ladite bascule recevant ledit signal logique et la sortie de ladite bascule bistable délivrant un signal logique synchronisé sur ledit signal d'horloge, ledit détecteur et ladite voie auxiliaire délivrant chacune une impulsion de comparaison de phase de même amplitude crête à crête, dont la différence entre la durée de chacune des impulsions est une mesure du déphasage du signal logique par rapport audit signal d'horloge, en l'absence d'ondulation crête à l'équilibre en détection différentielle.

**Patentansprüche**

1.  Detektor für den Übergang eines logischen Signals, der ein logisches Exklusiv-Oder-Gatter aufweist, dessen erster Eingang das logische Signal empfängt und dessen zweiter Eingang das logische Signal über einen Verzögerungskreis von einer bestimmten Verzögerung empfängt, wobei dieser Dektektor außerdem einen Zusatzverzögerungskreis aufweist, der dem Verzögerungskreis über eine Phasenverriegelungsschleife zugeordnet ist, wobei diese Phasenverriegelungsschleife es gestattet, ausgehend von einem Bezugsfrequenzsignal, das an den Eingang des Zusatzverzögerungskreises angelegt ist, ein gemeinsames Phasensteuersignal zu erzeugen, das die Regelung der von dem Verzögerungskreis und dem Zusatzverzögerungskreis eingeführten Verzögerung auf einen zur Periode des Bezugsfrequenzsignals proportionalen Wert gestattet, was bei jedem Übergang des logischen Signals die Erzeugung eines kalibrierten Impulses gestattet, dessen Dauer zu der Periode des Bezugsfrequenzsignals proportional ist.

2.  Detektor nach Anspruch 1, **dadurch gekennzeichnet, dass** der Verzögerungskreis von einer Vielzahl von M kaskadenförmig geschalteten Umkehrkreisen mit gesteuerter Fortpflanzungszeit gebildet ist und dass der Zusatzverzögerungskreis von einer Vielzahl von 2N kaskadenförmig geschalteten Umkehrkreisen mit gesteuerter Fortpflanzungszeit gebildet ist, wobei diese Umkehrkreise durch das von der Phasenverriegelungsschleife gelieferte Phasensteuersignal gesteuert werden.

3. Detektor nach Anspruch 2, **dadurch gekennzeichnet, dass** die den Verzögerungskreis bzw. den Zusatzverzögerungskreis bildenden Umkehrkreise identisch sind, wobei die durch diesen Verzögerungskreis erzeugte Verzögerung τ gleich dem Produkt aus dem Verhältnis der Anzahl M von den Verzögerungskreis bildenden Umkehrkreisen zur Anzahl 2N von den Zusatzverzögerungskreis bildenden Umkehrkreisen und der Periode Tref des Bezugsfrequenzsignals

$$\tau = \frac{M}{2N} \times \text{Tref}$$

ist.

4. Detektor nach einem der Ansprüche 1 bis 3, **dadurch gekennzeichnet, dass** die Phasenverriegelungsschleife mindestens folgendes aufweist:

   - einen Phasen/Frequenz-Vergleicher mit drei Zuständen, der auf dem ersten Eingang das Bezugsfrequenzsignal und auf dem zweiten Eingang das über den Zusatzverzögerungskreis gelieferte Bezugsfrequenzsignal empfängt, wobei der Phasen/Fre-quenz-Vergleicher ein Vergleichssignal vom Wert null bei Fehlen einer Phasen/Frequenz-Verschiebung zwischen den Signalen des ersten und des zweiten Eingangs und ein zur Phasen/Fre-quenz-Verschiebung zwischen den Signalen des ersten und des zweiten Eingangs proportionales Signal mit positivem oder negativem Wert liefert,
   - ein Tiefpassfilter, das dieses Vergleichssignal empfängt und das gemeinsame Phasensteuersignal liefert, das dem Verzögerungskreis und dem Zusatzverzögerungskreis geliefert wird.

5. Detektor nach Anspruch 4, **dadurch gekennzeichnet, dass** der Phasenverriegelungskreis außerdem Mittel zur Initialisierung des Phasen/Frequenz-Vergleichers mit drei Zuständen und der durch den Zusatzverzögerungskreis eingeführten Anfangsgesamtverzögerung auf ihrem Minimumwert aufweist, so dass eine Erhöhung des Werts der durch diesen Zusatzverzögerungskreis eingeführten Gesamtverzögerung bis zu einem Gleichgewichtswert zugelassen wird, der der Periode des Bezugssignals entspricht.

6. Verwendung eines Detektors für den Übergang eines logischen Signals nach einem der vorhergehenden Ansprüche zur Bildung eines Phasenvergleichers, bei der dem Detektor parallel zu dem Fluss der von dem logischen Signal dargestellten Daten ein Zusatzkanal zugeordnet ist, der von einem bistabilen Kippkreis, der ein dem logischen Signal zugeordnetes Taktsignal empfängt, und einem Exklusiv-Oder-Gatter gebildet wird, wobei ein Eingang des Exklusiv-Oder-Gatters und der Dateneingang des Kippkreises das logische Signal empfangen und der Ausgang des bistabilen Kippkreises ein auf dieses Taktsignal synchronisiertes logisches Signal liefert, wobei dieser Detektor und dieser Zusatzkanal jeweils einen Phasenvergleichsimpuls derselben Spitze-Spitze-Amplitude liefern, bei dem die Differenz zwischen der Dauer jedes der Impulse ein Maß für die Phasenverschiebung des logischen Signals bezüglich des Taktsignals bei Fehlen von Spitzenwellung im Gleichgewichtszustand bei Differenzerfassung ist.

**Claims**

1. Logic signal state transition detector comprising an exclusive OR logic gate, a first input of which receives the said logic signal and a second input of which receives the said logic signal via a fixed delay circuit, the said detector further comprising an auxiliary delay circuit linked to the said delay circuit by a phase-locked loop, the said phase-locked loop allowing a common phase control signal to be generated from a reference frequency signal which allows the delay produced by the said delay circuit and the said auxiliary delay circuit to be controlled to a level proportional to the period of the reference frequency signal, the said reference frequency signal being applied to the input of the auxiliary delay circuit, which in turn allows a calibrated pulse whose length is proportional to the period of the reference frequency signal to be generated for each state transition of the said logic signal.

2. Detector according to claim 1 **characterized in that** the said delay circuit is constituted by a plurality of M cascaded inverters with a fixed propagation time, and in which the said auxiliary delay circuit is constituted by a plurality of 2N cascaded inverter circuits with a fixed propagation time, the said inverters being controlled by the said phase signal produced by the said phase-locked loop.

3. Detector according to claim 2 **characterized in that** the said inverters constituting the said delay circuits and the delay auxiliary circuit are identical, the delay

$\tau$ produced by the said delay circuit being equal to the product of the ratio of the number M of inverters constituting the delay circuit to the number 2N of inverters constituting the auxiliary delay circuit and the period $T_{ref}$ of the reference frequency signal,

$$t = \frac{M}{2N} \times T_{ref}$$

4. Detector according to claims 1 to 3 **characterized in that** the said phase-locked loop comprising at least:

   - a three-state phase/frequency comparator receiving at a first input the said reference frequency signal and at a second input the said reference frequency signal fed via the said auxiliary delay circuit, the said phase/frequency comparator producing a comparison signal equal to zero in the absence of a phase/frequency shift between the signals at the first and second inputs, respectively, and a signal of positive or negative sign proportional to the phase/frequency shift between the signals at the first and second inputs;
   - a low-pass filter receiving the said comparator signal which produces the said common phase control signal to the said delay and auxiliary delay circuits.

5. Detector according to claim 4 **characterized in that** the said phase-locked loop also comprises means for initialising the said three-state phase/frequency comparator and to reset the global initial delay produced by the said auxiliary delay circuit to its minimal value, so as to allow the global delay generated by the auxiliary delay circuit to increase up to the equilibrium value corresponding to the reference signal period.

6. Utilisation of a logic state transition detector according to one of the preceding claims for the realisation of a phase comparator, in which is associated with the said detector, in parallel with the data stream represented by the said logic signal, an auxiliary channel constituted by a bistable flip-flop receiving a clock signal associated with the said logic signal and an exclusive OR gate, an input of the said exclusive OR gate and a data input of the said flip-flop receiving the said logic signal, and the output of the said bistable flip-flop producing a logic signal synchronised to the said clock signal, the said detector and the said auxiliary channel each generating a phase comparison pulse of the same peak-to-peak amplitude, in which the difference between the lengths of each of the pulses is a measure of the phase shift between the logic signal and the said clock signal, in the case where there is no peak fluctuation at equilibrium in differential detection mode.

FIG.1. (ART ANTERIEUR)

FIG.2a.

FIG.2b.

$2N = 16$    $Tref = 2N \cdot Tp$

$$\tau = \frac{M}{2N} \, Tref$$

FIG.2c.

FIG.3a.

FIG.3b.

EP 0 697 768 B1

# FIG.4a

BASCULE BISTABLE

CLO

50

VA

S1

51

Données

DÉTECTEUR DE TRANSITION CLK

$V_{en}$

$V_s$

$S_p$

VD

$F_{MOT} = \dfrac{1}{T_{REF}}$

# FIG.4b

$(V_{en})$
Données

CLO

# FIG.4c

$\Delta\varphi$

$(V_{en})$
Données

CLO

S1

$\Delta\varphi$

$S_p$

$\tau = \dfrac{T_{bit}}{2}$

$\tau$

$\tau$

$\tau$

15